(19) **Europäisches Patentamt**

**European Patent Office**

**Office européen des brevets**

(11) Veröffentlichungsnummer: **0 287 919 B1**

(12) # EUROPÄISCHE PATENTSCHRIFT

(45) Veröffentlichungstag der Patentschrift: **05.08.92**

(21) Anmeldenummer: **88105738.4**

(22) Anmeldetag: **11.04.88**

(51) Int. Cl.⁵: **G01R 31/02**, H03K 17/08, G05F 1/56

(54) **Schaltungsanordnung zum Überwachen eines Stromkreises auf Unterbrechung.**

(30) Priorität: **10.04.87 DE 3712177**

(43) Veröffentlichungstag der Anmeldung:
**26.10.88 Patentblatt 88/43**

(45) Bekanntmachung des Hinweises auf die
Patenterteilung:
**05.08.92 Patentblatt 92/32**

(84) Benannte Vertragsstaaten:
**BE DE FR IT NL**

(56) Entgegenhaltungen:
**EP-A- 0 010 882**      **EP-A- 0 195 267**
**EP-A- 0 255 067**      **DE-A- 3 139 783**
**DE-A- 3 533 523**      **US-A- 4 390 833**

(73) Patentinhaber: **SIEMENS AKTIENGESELL-SCHAFT**
**Wittelsbacherplatz 2**
**W-8000 München 2(DE)**

(72) Erfinder: **Breunig, Hans, Dipl.-Ing.**
**Reinhold-Schneider-Strasse 28**
**W-7500 Karlsruhe(DE)**
Erfinder: **Knauer, Detlev, Dipl.-Ing.**
**Blumenstrasse 12**
**W-6742 Herxheim 2(DE)**

**Beschreibung**

Die Erfindung betrifft eine Schaltungsanordnung zum Überwachen eines Stromkreises auf Unterbrechung gemäß dem Oberbegriff des Anspruchs 1.

Die sichere Erkennung und Meldung von Fehlern in Automatisierungsanlagen ist wegen deren Komplexität sowie der hohen Investitions- und Produktionswerte von großer Bedeutung. Zur Verbesserung der Verfügbarkeit müssen häufig auftretende Störungen in den Signalleitungen, wie Kurzschlüsse und Unterbrechungen, sicher erkannt werden.

Aus der DE-OS 34 36 844 ist bekannt, in einer Prüfphase über die Zuleitungen zu Meßwertgebern Prüfströme zu schicken. Im Falle eines Leitungsbruchs fällt der Prüfstrom aus und es wird ein diesen Zustand kennzeichnendes Meldesignal abgegeben. Der wesentliche Nachteil dieser Lösung ist, daß nicht benutzte Ausgänge, an die kein Lastwiderstand angeschlossen ist, Leitungsbruch melden. Es müssen daher zusätzliche Maßnahmen getroffen werden, solche Fehlermeldungen gezielt auszublenden. Diesen Nachteil weisen alle Anordnungen auf, bei denen die Leitungsunterbrechung geprüft wird, während der Schalttransistor gesperrt ist.

In der EP-A-0 010 882 ist eine Schaltungsanordnung zum Überwachen eines Laststromkreises beschrieben, der eine Last und einen den Laststrom schaltenden Transistor enthält. Dieser wird stets in der Sättigung betrieben, so daß seine Kollektor-Emitter-Spannung ein Maß für den Laststrom ist. Der Laststromkreis wird dadurch überwacht, daß die Kollektor-Emitter-Spannung des Transistors überwacht wird und aus dieser Spannung mittels einer Logikschaltung Schlüsse auf den Zustand des Laststromkreises gezogen und entsprechende Meldesignale abgegeben werden. Im Falle eines zu großen Laststromes wird der Transistor gesperrt.

Aus der DE-A-31 39 783 ist eine Steuerschaltung für einen eine Last schaltenden Transistor bekannt, mit welcher der Steuerstrom des Transistors entsprechend dem geforderten Laststrom eingestellt wird. Hierzu ist der Basiselektrode des Transistors eine Stromsteuerung vorgeschaltet, die ihrerseits mittels eines Reglers so gesteuert wird, daß die Kollektor-Emitter-Spannung des Transistors etwa konstant bleibt. Bei kleinen Lastströmen sind dadurch auch nur kleine Steuerleistungen erforderlich, und es ergibt sich folglich ein guter Wirkungsgrad. Maßnahmen zum Überwachen des Laststromkreises auf fehlerhafte Zustände sind nicht vorgesehen.

Der vorliegenden Erfindung liegt die Aufgabe zugrunde, einen Laststromkreis, der eine Last und einen den Laststrom schaltenden Transistor enthält, wobei die am Transistor abfallende Spannung auf einen konstanten Wert geregelt ist, zuverlässig auf Unterbrechung zu überwachen. Die Überwachung soll in der Durchschaltphase des Transistors erfolgen, und es soll kein zusätzlicher, einen Spannungsabfall und damit Verlustleistung bewirkender Widerstand in den Stromkreis geschaltet sein.

Diese Aufgabe wird erfindungsgemäß mit den im kennzeichnenden Teil des Anspruchs 1 angegebenen Maßnahmen gelöst.

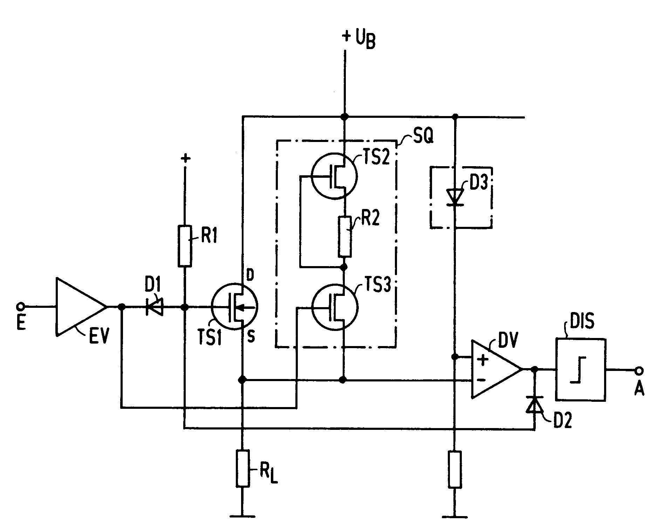

Anhand der Zeichnung werden im folgenden die Erfindung sowie weitere Vorteile und Ausgestaltungen näher beschrieben und erläutert.

Eine Last $R_L$ liegt in Reihe mit der Drain-Source-Strecke eines Transistors TS1 an einer Spannung $+U_B$. Die Ein- und Ausschaltsignale für den Transistor TS1 sind einem Eingang E zugeführt, von wo sie über einen Eingangsverstärker EV und eine Entkopplungsdiode D1 an die Gate-Elektrode des Transistors TS1 gelangen. Ein Differenzverstärker DV vergleicht den Spannungsabfall an der Drain-Source-Strecke mit einer Referenzspannung, die von einer von einem Konstantstrom durchflossenen Diode D3 erzeugt wird. Der Ausgang des Differenzverstärkers DV ist über eine zweite Entkopplungsdiode D2 mit der Gate-Elektrode des Transistors TS1 verbunden. Ein Widerstand R1 ist zwischen die Gate-Elektrode und eine positive Spannung geschaltet, die größer sein sollte als die Spannung $+U_B$.

Ein positives Eingangssignal am Eingang E verstärkt der Eingangsverstärker EV so, daß die Entkopplungsdiode D1 gesperrt ist und der Transistor TS1 Spannung an die Last RL schaltet. Die Gate-Elektrode erhält vom Differenzverstärker DV eine solche Steuerspannung, daß der Spannungsabfall an der Drain-Source-Strecke, der durch den Laststrom bewirkt wird, gleich der Referenzspannung gehalten wird, und zwar weitgehend unabhängig von der Größe der Last $R_L$. Mit zunehmendem Widerstand der Last $R_L$ sinkt die Ausgangsspannung des Differenzverstärkers DV, bis sie schließlich einen in einem Diskriminator DIS eingestellten Schwellwert erreicht. Dieser Schwellwert entspricht einem Lastwiderstand, der bei fehlerfreiem Zustand der Last und deren Zuleitung nicht auftritt. Das Signal, welches der Diskriminator DIS bei allen größeren Widerstandswerten abgibt, wird daher als Leitungsbruch-Meldesignal über einen Ausgang A abgegeben. Der Leitungsbruch wird somit bei eingeschaltetem Transistor TS1 festgestellt. Mit einem weiteren im Diskriminator DIS eingestellten Schwellwert kann der Lastkreis auch auf Kurzschluß überwacht werden.

Zum Sperren des Transistors TS1 wird dem Eingang E "O"-Signal zugeführt. Über der Drain-Source-Strecke liegt dann die volle Versorgungsspannung $+U_B$, so daß der Differenzverstärker DV maximale Spannung abgibt. Die Entkopplungsdiode D2 verhindert einen Kurzschluß der Ausgänge der Verstärker EV und DV.

Im gewählten Beispiel mit einem n-Kanal-Transistor gibt, wenn das Signal am Eingang E den Transistor TS1 in den Sperrzustand steuert, der Differenzverstärker DV ein Signal ab, bei dem der Diskriminator DIS keinen Leitungsbruch meldet. Bei Abänderungen des Ausführungsbeispiels, z. B. p-Kanal-Transistor, negative Versorgungsspannung, kann der Fall eintreten, daß der Diskriminator ein Meldesignal abgibt, wenn der Transistor vom Eingangssignal in den Sperrzustand gesteuert ist. In diesem Falle wird zweckmäßig das Ausgangssignal gesperrt, wenn dem Eingang E Sperrsignal für den Transistor TS1 zugeführt ist. Hierzu ist ein UND-Glied vorgesehen.

Zur Verringerung des Einflusses der Toleranzen der Regelstrecke, vor allem der des Transistors TS1, ist dessen Drain-Source-Strecke eine Stromquelle SQ mit einem Transistor TS2 und einem Widerstand R2 parallelgeschaltet, die einen eingeprägten Strom liefert, der kleiner ist als der minimale Laststrom im ungestörten Zustand des Lastkreises. Steigt der Widerstand im Lastkreis auf einen solchen Wert an, daß der durch den eingeprägten Strom verursachte Spannungsabfall größer ist als die um die Referenzspannung verminderte Versorgungsspannung $+U_B$, sperrt der Differenzverstärker DV den Transistor TS1. Es genügt daher für die Überwachung auf Leitungsbruch zu prüfen, ob der Transistor TS1 in den Sperrzustand gesteuert ist. Die Fehlermeldung hängt in diesem Falle nur von der Größe des eingeprägten Stromes und dem Lastwiderstand ab, nicht dagegen von den Kennlinien des Transistors TS1 und nur unwesentlich von der Offset-Spannung und der Verstärkung des Verstärkers DV. Zweckmäßig wird die Stromquelle SQ mit einem Transistor TS3 gesperrt, wenn der Transistor TS1 in den Sperrzustand geschaltet ist, damit während der Sperrphase nicht unnötig Strom verbraucht wird. Die im Ausführungsbeispiel verwendete Stromquelle ist daher abschaltbar; der Steuereingang des Transistors TS3 ist an den Eingangsverstärker EV angeschlossen. Damit die Stromquelle nicht vom Ausgangssignal des Differenzverstärkers DV abgeschaltet wird, ist die Entkopplungsdiode D1 vorgesehen.

## Patentansprüche

1.  Schaltungsanordnung zum Überwachen eines Laststromkreises, der eine Last ($R_L$) und einen den Laststrom schaltenden Transistor (TS1) enthält, mittels einer Einrichtung zum Melden von Fehlern im Laststromkreis, **dadurch gekennzeichnet,** daß eine Regelschaltung mit einem Regler (DV) und mit dem Transistor (TS1) als Stellglied den Spannungsabfall am Transistor (TS1) auf einen konstanten Wert regelt und daß an den Regler (DV) ein Diskriminator (DIS) angeschlossen ist, der ein Meldesignal abgibt, wenn das Ausgangssignal des Reglers (DV) außerhalb eines vorgegebenen Bereiches liegt.

2.  Schaltungsanordnung nach Anspruch 1, **dadurch gekennzeichnet,** daß der Diskriminator (DIS) ein Leitungsbruch-Meldesignal abgibt, wenn das Ausgangssignal des Reglers (DV) in einem durch einen Schwellwert bestimmten Bereich liegt, der einem Widerstandswert entspricht, der größer ist als die im fehlerfreien Zustand des Laststromkreises auftretenden Widerstandswerte.

3.  Schaltungsanordnung nach Anspruch 1, **dadurch gekennzeichnet,** daß im Diskriminator ein Schwellwert zum Überwachen des Laststromkreises auf Kurzschluß eingestellt ist.

4.  Schaltungsanordnung nach einem der Ansprüche 1 bis 3, **dadurch gekennzeichnet,** daß dem Transistor (TS1) eine Stromquelle (SQ) parallelgeschaltet ist, die einen eingeprägten Strom abgibt, der kleiner ist als der minimale Laststrom im ungestörten Zustand des Laststromkreises, und daß ein Leitungsbruch-Meldesignal abgegeben wird, wenn der Transistor (TS1) in den Sperrzustand gesteuert wird.

5.  Schaltungsanordnung nach Anspruch 4, **dadurch gekennzeichnet,** daß die Stromquelle zusammen mit dem Laststrom abschaltbar ist.

## Claims

1.  Circuit arrangement for monitoring a load current circuit which contains a load (RL) and a transistor (TS1) switching the load current, by means of a device for signalling errors in the load current circuit, characterised in that a control circuit with a controller (DV) and with the transistor (TS1) as the actuator controls the voltage drop at the transistor (TS1) to a constant value, and in that connected to the controller (DV) is a discriminator (DIS) which emits an alarm signal when the output signal of the controller (DV) is outside a predetermined range.

2.  Circuit arrangement according to claim 1, characterised in that the discriminator (DIS) emits an open circuit-alarm signal when the output signal of the controller (DV) is in a range determined by a threshold value, which corresponds to a resistance value which is greater than the resistance values occurring in the error-free state of the load current circuit.

3. Circuit arrangement according to claim 1, characterised in that a threshold value is set in the discriminator for monitoring the load current circuit for short-circuiting.

4. Circuit arrangement according to one of claims 1 to 3, characterised in that connected in parallel with the transistor (TS1) is a current source (SQ) which supplies a load-independent current which is smaller than the minimum load current in the undisturbed state of the load current circuit, and in that an open circuit-alarm signal is emitted when the transistor (TS1) is controlled into the blocking state.

5. Circuit arrangement according to claim 4, characterised in that the current source can be switched off together with the load current.

**Revendications**

1. Montage pour contrôler un circuit de charge, qui comporte une charge ($R_L$) et un transistor (TS1) qui commande le courant de charge, à l'aide d'un dispositif servant à signaler des défauts dans le circuit de charge, caractérisé par le fait qu'un circuit de régulation comportant un régulateur (DV) et le transistor (TS1), en tant que circuit de réglage, règle la chute de tension dans le transistor (TS1) à une valeur constante et qu'au régulateur (DV) est raccordé un discriminateur (DIS), qui délivre un signal de signalisation lorsque le signal de sortie du régulateur (DV) se situe en dehors d'une zone prédéterminée.

2. Montage suivant la revendication 1, caractérisé par le fait que le discriminateur (DIS) délivre un signal de signalisation d'interruption de lignes lorsque le signal de sortie du régulateur (DV) est situé dans une gamme déterminée par une valeur de seuil qui correspond à une valeur de résistance qui est supérieure aux valeurs de résistance apparaissant lorsque le circuit de charge ne présente aucun défaut.

3. Montage suivant la revendication 1, caractérisé par le fait qu'une valeur de seuil pour le contrôle d'un éventuel court-circuit dans le circuit de charge est réglée dans le discriminateur.

4. Montage suivant l'une des revendications 1 à 3, caractérisé par le fait qu'en parallèle avec le transistor (TS1) est branchée une source de courant (SQ), qui délivre un courant injecté, qui est inférieur au courant de charge minimum lorsque le circuit de charge est à l'état non perturbé, et qu'un signal de signalisation de rupture de ligne est délivré lorsque le transistor (TS1) est placé à l'état bloqué.

5. Montage suivant la revendication 4, caractérisé par le fait que la source de courant peut être débranchée en même temps que le courant de charge est interrompu.